# EUROPEAN PATENT SPECIFICATION

(11) **EP 3 442 039 B1**
(45) Date of publication and mention of the grant of the patent: **05.08.2020**
(21) Application number: 17763258.5
(22) Date of filing: 07.03.2017
(51) Int. Cl.: H01L 35/32, H01L 35/08, H01L 35/30

(54) **THERMOELECTRIC CONVERSION MODULE**
MODUL ZUR THERMOELEKTRISCHEN UMWANDLUNG
MODULE DE CONVERSION THERMOÉLECTRIQUE

(30) Priority: 10.03.2016 JP 2016047301
(43) Date of publication of application: 13.02.2019
(73) Proprietor: Atsumitec Co., Ltd., Hamamatsu-shi, Shizuoka 433-8118 (JP)
(72) Inventor: UCHIYAMA, Naoki, Hamamatsu-shi Shizuoka 433-8118 (JP); KUBO, Kazuya, Hamamatsu-shi Shizuoka 433-8118 (JP)
(74) Representative: Blumbach · Zinngrebe Patentanwälte PartG mbB
(86) International application number: PCT/JP2017/009041
(87) International publication number: WO 2017/154918

(56) References cited:
- EP-A1- 2 408 032
- WO-A1-2008/054015
- JP-A- 2002 084 005
- JP-A- 2006 253 341
- US-A1- 2002 024 154
- US-A1- 2010 059 096
- US-A1- 2012 025 343

## Description

### Technical Field

The present invention relates to a thermoelectric conversion module which generates electricity by thermoelectric conversion based on the Seebeck effect.

### Background Art

The thermoelectric conversion module is a module comprising thermoelectric conversion elements capable of converting thermal energy into electrical energy through the Seebeck effect. Thermoelectric conversion modules and thermoelectric conversion elements for forming them are attracting attention as environmentally-friendly energy-saving technology, because they can convert waste heat, expelled from industrial or consumer processes or moving vehicles, into available electricity by making use of this energy conversion property.

Such thermoelectric conversion modules are commonly formed by connecting thermoelectric conversion elements (p-type and n-type semiconductor elements) by electrodes. A thermoelectric conversion module of this type is disclosed in Patent Document 1, for example. The thermoelectric conversion module in Patent Document 1 comprises a pair of substrates, a plurality of thermoelectric conversion elements which are electrically connected to first electrodes arranged on one of the substrates at their first ends, and to second electrodes arranged on the other substrate at their opposite, second ends, and connectors each electrically connecting the first electrode connected to a thermoelectric conversion element to the second electrode connected to an adjacent thermoelectric conversion element. Furthermore, US 2010/0059096 A1 discloses a thermoelectric module which has a stress-mitigation unit including a slit and an incision that relieves stress produced by temperature difference of both ends of a semiconductor element.

### Prior Art Document

### Patent Document

Patent Document 1: Japanese Unexamined Patent Application Publication No. 2013-115359

### Summary of the Invention

### Problems to be solved by the Invention

However, when the thermoelectric conversion module configured as disclosed in Patent Document 1 is applied to a heating source such as an exhaust system of an engine, if the temperature of the thermoelectric conversion elements increases too greatly due to the module's location near the engine or the amount of heat increased, for example by an increase in the amount of exhaust gas from the engine, the electricity generation performance of the thermoelectric conversion elements decreases.

The present invention has been made in view of the above problem. An object of the present invention is to provide a thermoelectric conversion module which can maintain high electricity generation performance even when applied to a relatively high-temperature heat source.

### Means for Solving the Problems

In order to achieve the above object, the thermoelectric conversion module applied to a heating source according to the present invention comprises a plurality of thermoelectric conversion elements arranged adjacent to each other, first electrodes located away from the heating source and joined to first ends of the thermoelectric conversion elements to electrically connect the first ends of adjacent thermoelectric conversion elements, second electrodes located nearer to the heating source and joined to opposite, second ends of the thermoelectric conversion elements to electrically connect the second ends of adjacent thermoelectric conversion elements, wherein the thermoelectric conversion elements each comprise a first structural portion joined to the first electrode and a second structural portion joined to the second electrode, the second electrode being smaller in volume than the first electrode, wherein the thermoelectric elements are diffusion-bonded to the second electrodes.

### Advantageous Effects of the Invention

The thermoelectric conversion module according to present invention can maintain high electricity generation performance even when applied to a relatively high-temperature heat source.

### Brief Description of the Drawings

FIG. 1 is a perspective view of a thermoelectric conversion module according to an embodiment.
FIG. 2 is a top view of the thermoelectric conversion module according to the embodiment.
FIG. 3 is a cross-sectional view of the thermoelectric conversion module along line III-III in FIG. 2.
FIG. 4 is a diagram schematically showing the structure of a thermoelectric conversion element for use in the thermoelectric conversion module according to the present embodiment.
FIG. 5 is a side view of an electrode for use in the thermoelectric conversion module according to the present embodiment.
FIG. 6 is a diagram schematically showing the structure of a thermoelectric conversion element according to a variant.
FIG. 7 is a diagram schematically showing the structure of a thermoelectric conversion element according to another variant.

### Mode of Carrying out the Invention

With reference to the accompanying drawings, how to carry out the thermoelectric conversion module according to the present invention will be described in detail based on an embodiment. The drawings used in explanation of the embodiment show the thermoelectric conversion module according to the present invention and its components, schematically; in order to help understanding, the drawings may contain partial emphasis, enlargement, contraction, omission or the like, and thus, may not necessarily show the components on an accurate scale and in an accurate shape. Further, numerical values mentioned in connection with the embodiment are all given by way of example; they may be varied as necessary.

### 〈Embodiment〉

### (Configuration of a thermoelectric conversion module)

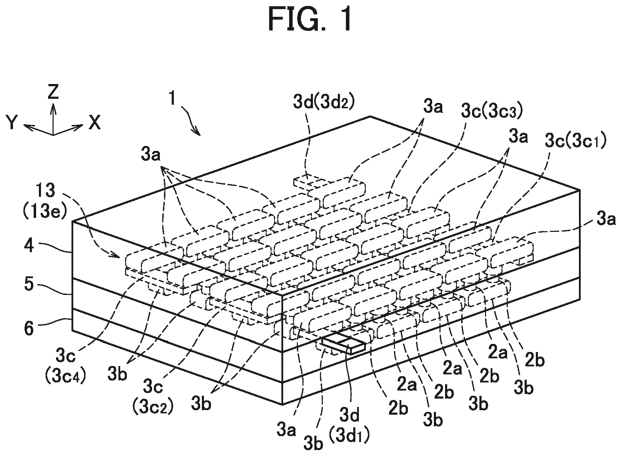

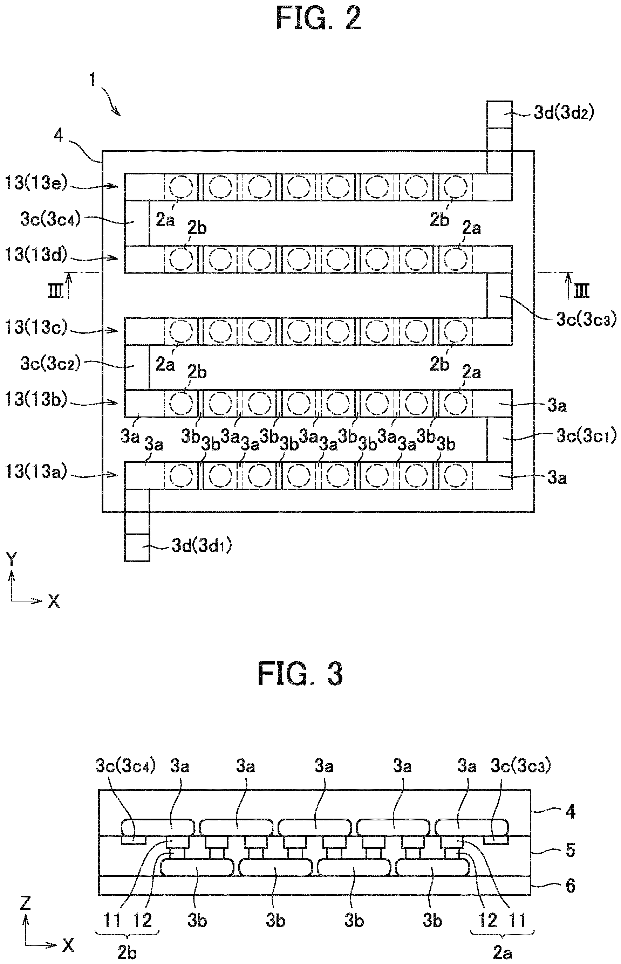

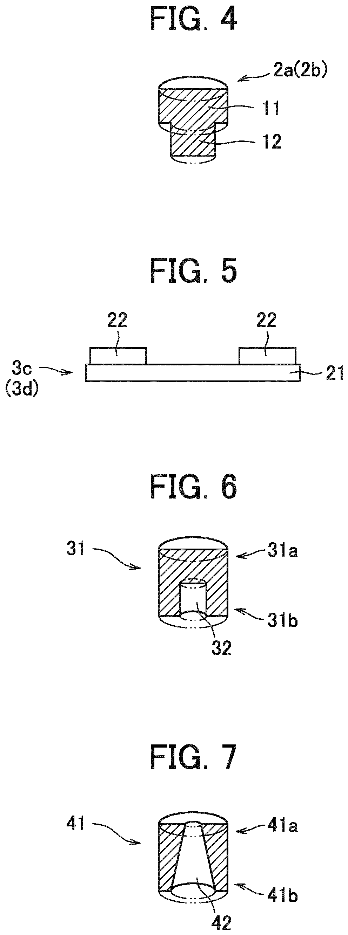

With reference to FIGS. 1 to 4, the configuration of a thermoelectric conversion module 1 according to an embodiment will be described. FIG. 1 is a perspective view of the thermoelectric conversion module 1 according to the embodiment. FIG. 2 is a top view of the thermoelectric conversion module 1 according to the embodiment. FIG. 3 is a cross-sectional view of the thermoelectric conversion module along line III-III in FIG. 2. FIG. 4 is a diagram schematically showing the structure of a thermoelectric conversion element for forming the thermoelectric conversion module 1. In FIG. 1, one direction is referred to as X direction, and directions perpendicular to X direction are referred to as Y direction and Z direction. Specifically, the direction parallel to the height of the thermoelectric conversion module 1 is referred to as Z direction.

As seen from FIGS. 1 to 3, the thermoelectric conversion module 1 according to the present embodiment comprises first and second thermoelectric conversion elements 2a, 2b arranged adjacent to each other, and first and second electrodes 3a, 3b joined to the opposite ends of the first and second thermoelectric conversion elements 2a, 2b. The thermoelectric conversion module 1 according to the present embodiment further comprises connecting electrodes 3c which connect the first electrodes 3a located at each X-way end of the thermoelectric conversion module 1 to each other, and extraction electrodes 3d which function as external connection electrodes of the thermoelectric conversion module 1. The thermoelectric conversion module 1 according to the present embodiment further comprises a first covering layer 4 provided to cover the first electrodes 3a, a second covering layer 5 provided to cover the first and second thermoelectric conversion elements 2a, 2b and the connecting electrodes 3c, and a support substrate 6 provided to support the second electrodes 3b. The thermoelectric conversion module 1 is arranged with the support substrate 6 side in contact with a heating source such as an automotive engine.

When mentioning the individual connecting electrodes 3c, they will be referred to as connecting electrode 3c₁, connecting electrode 3c₂, connecting electrode 3c₃ and connecting electrode 3c₄, and when mentioning the individual extraction electrodes 3d, they will be referred to as extraction electrode 3d₁ and extraction electrode 3d₂.

In the present embodiment, the first thermoelectric conversion elements 2a are made of an n-type semiconductor material, and the second thermoelectric conversion elements 2b are made of a p-type semiconductor material. The first and second thermoelectric conversion elements 2a, 2b are arranged alternately in a matrix (eight in X direction, five in Y direction, forty in all), where adjacent first and second thermoelectric conversion elements 2a, 2b are electrically connected by first and second electrodes 3a, 3b.

In the present embodiment, the first thermoelectric conversion element 2a as well as the second thermoelectric conversion element 2b has a shape consisting of two cylinders of different diameter joined together, as shown in FIGS. 3 and 4. More specifically, as shown in FIG. 4, the first thermoelectric conversion element 2a as well as the second thermoelectric conversion element 2b consists of a first cylindrical portion (first structural portion) 11 with a large diameter, or outer measurement (5mm in diameter, for example) adjacent to the first electrode 3a and a second cylindrical portion (second structural portion) 12 with a small diameter (3mm in diameter, for example) adjacent to the second electrode 3b. In other words, each thermoelectric conversion element consists of a first cylindrical portion 11 joined to the first electrode 3a and a second cylindrical portion 12 smaller in volume than the first cylindrical portion 11 and joined to the second electrode 3b, and thus, has a stepped outer shape. By providing a difference in volume between the portions constituting each thermoelectric conversion element, conduction of heat from the heating source is controlled. The control of conduction of heat will be described in detail when explaining a test result.

The first electrode 3a and the second electrode 3b are of the same shape (plate-like shape) and made of copper, for example. The first electrodes 3a are arranged such that five are arranged in a row in X direction and five are arranged in a row in Y direction (thus, twenty-five in all). The first electrodes 3a located at the X-way ends are each joined to a first thermoelectric conversion element 2a or a second thermoelectric conversion element 2b, at an end, and joined to a connecting electrode 3c or an extraction electrode 3d, at the opposite end. Meanwhile, the second electrodes 3b are arranged such that four are arranged in a row in X direction and five are arranged in a row in Y direction (thus, twenty in all). The second electrodes 3b are each joined to a first thermoelectric conversion element 2a, at an end, and joined to a second thermoelectric conversion element 2b, at the opposite end. As seen from FIGS. 1 and 3, the first and second thermoelectric conversion elements 2a, 2b are sandwiched between the first electrodes 3a and the second electrodes 3b in Z direction.

As a result of this arrangement of the first and second thermoelectric conversion elements 2a, 2b and the first and second electrodes 3a, 3b, the first and second thermoelectric conversion elements 2a, 2b are connected in series. Particularly in the present embodiment, four first thermoelectric conversion elements 2a, four second thermoelectric conversion elements 2b, five first electrodes 3a and four second electrodes 3b arranged in a X-way row form a series circuit element 13. Accordingly, the thermoelectric conversion module 1 contains five series circuit elements 13 in all. Series circuit elements 13 adjacent to each other in Y direction are connected by a connecting electrode 3c at an end. When mentioning the individual series circuit elements 13, they will be referred to as series circuit element 13a, series circuit element 13b, series circuit element 13c, series circuit element 13d and series circuit element 13e.

The first electrode 3a as well as the second electrode 3b is not limited to a copper plate; they may be made of another electrically-conductive material (metal such as aluminum, for example). The number and shape of the first and second electrodes 3a, 3b are not limited to the above but may be changed appropriately depending on the first and second thermoelectric conversion elements 2a, 2b (in other words, the magnitude of electromotive force). Further, the first and second electrodes 3a, 3b may be arranged to connect the first and second thermoelectric conversion elements 2a, 2b in parallel.

The connecting electrode 3c and the extraction electrode 3d are identical in structure. Specifically, as shown in FIG. 5, they are each composed of a metal mesh 21 and two metal plates 22 fixed to the metal mesh 21 at opposite ends. The connecting electrode 3c and the extraction electrode 3d, which include a metal mesh 21 with high flexibility, have flexibility. The ratio of openings and the size of the opening in the metal mesh 21 may be selected appropriately to ensure that the connecting electrode 3c and the extraction electrode 3d have high flexibility.

Although in the present embodiment, the metal mesh 21 and the metal plate 22 are made of copper, they are not limited to copper but may be made of another metal. Particularly, materials that can provide high electrical conductivity while ensuring high flexibility of the connecting electrode 3c and the extraction electrode 3d are desirable. The connecting electrode 3c and the extraction electrode 3d do not necessarily need to contain a metal mesh 21 if they can have high flexibility; they may be formed using a metallic material having a structure other than mesh.

As shown in FIG. 2, to a series circuit element 13a with a -Y-side extraction electrode 3d₁ joined at an end, a connecting electrode 3c₁ is joined at the opposite (+X-side) end, and the connecting electrode 3c₁ connects the series circuit element 13a to a +Y-side adjacent series circuit element 13b. To the series circuit element 13b, a connecting electrode 3c₂ is joined at a (-X-side) end opposite to the end connected to the series circuit element 13a, and the connecting electrode 3c₂ connects the series circuit element 13b to a +Y-side adjacent series circuit element 13c. In like manner, the series circuit element 13c is connected to a series circuit element 3d at a +X-side end by a connecting electrode 3c₃, and the series circuit element 13d is connected to a series circuit element 13e at a -X-side end by a connecting electrode 3c₄. To the series circuit element 13e, an extraction electrode 3d₂ is joined at a +X-side end.

In the thermoelectric conversion module 1, the series circuit elements 13 connected to each other by the connecting electrodes 3c in this manner form a zigzag series circuit. The series circuit is provided with the extraction electrodes 3d for external connection, at the opposite ends, which enable electricity generated by the thermoelectric conversion module 1 to be extracted externally. To form the zigzag series circuit, the first and second thermoelectric elements 2a, 2b forming the series circuit elements 13b, 13d alternate in reverse order, as compared with those forming the series circuit elements 13a, 13c, 13e.

In the present embodiment in which the connecting electrodes 3c and extraction electrodes 3d having flexibility are joined at the ends of the series circuit elements 13, the connecting electrodes 3c and extraction electrodes 3d do not separate from the first electrodes 3a even when an increase in temperature of the thermoelectric conversion module 1 brings about stress concentration. Further, when installed in a vehicle, the thermoelectric conversion module 1 configured as described above can prevent electrode separation due to vibration of the engine.

As seen from FIGS. 1 and 3, the first covering layer 4 covers the surfaces of the first electrodes 3a in a manner that the first electrodes 3a are buried therein. The first covering layer 4 is made of an insulating resin mixed with a metallic material functioning as a thermally-conductive material, such as aluminum, copper or aluminum nitride. The first covering layer 4 made of such mixture has a relatively high thermal conductivity and provides good electrical insulation around the first electrodes 3a.

As seen from FIGS. 1 to 3, the second covering layer 5 covers the first and second thermoelectric conversion elements 2a, 2b, the second electrodes 3b and the connecting electrodes 3c in a manner that the first and second thermoelectric conversion elements 2a, 2b, the second electrodes 3b and the connecting electrodes 3c are buried therein. The second covering layer 5 is made of an insulating resin mixed with a heat-insulating material. Heat-insulating materials usable for the second covering layer 5 include fibrous heat-insulating materials such as glass wool, and foam heat-insulating materials such as polystyrene foam.

The second covering layer 5 made of such mixture is lower in thermal conductivity than the first covering layer 5 and has a function of suppressing dissipation of heat from the first and second thermoelectric conversion elements 2a, 2b, the second electrodes 3b and the connecting electrodes 3c. Accordingly, the second covering layer 5 helps increase a temperature difference between the first electrodes 3a and the second electrodes 3b and keeps the temperature difference constant, thereby enabling greater electromotive force to be produced. The second covering layer 5 also provides good electrical insulation around the first and second thermoelectric conversion elements 2a, 2b, the second electrodes 3b and the connecting electrodes 3c.

Further, the second covering layer 5 holds the first and second thermoelectric conversion elements 2a, 2b, the second electrodes 3b and the connecting electrodes 3c relatively firmly, leading to an increased strength of the thermoelectric conversion module 1. Further, the first and second thermoelectric conversion elements 2a, 2b are completely covered, and thus, prevented from getting broken, tainted or something, which suppresses a decrease in thermoelectric conversion efficiency and reliability of the thermoelectric conversion module 1. Further, none of the joint surfaces between the first or second thermoelectric conversion element 2a, 2b and the first or second electrode 3a, 3b have an exposed edge. This increases the joint strength between the thermoelectric conversion elements and the electrodes, keeps down a decrease in joint strength due to aging, and prevents production of cracks at the joint surfaces.

The second covering layer 5 does not necessarily need to cover the first and second thermoelectric conversion elements 2a, 2b completely but may cover them partly, because also in that case, the second covering layer can produce a temperature difference between the first electrodes 3a and the second electrodes 3b, keep the temperature difference constant, and increase the strength of the thermoelectric conversion module 1. Like the first covering layer 4, the second covering layer 5 may contain a material functioning as a thermally-conducive material, although it is required that the second covering layer 5 be lower in thermal conductivity than the first covering layer 4. Although in the described example, the chief material for the first and second covering layers 4, 5 is a resin, it may be a ceramic or the like. Also in that case, it is required that the material covering the second electrodes 3b be lower in thermal conductivity than the material covering the first electrodes 3a.

As shown in FIGS. 1 and 3, the support substrate 6 is joined to the second electrodes 3b to support the second electrodes 3b. The support substrate 6 is made of an insulating material. The support substrate 6 may be a common insulating substrate such as a glass epoxy substrate.

### (Method for fabricating a thermoelectric conversion module)

A method for fabricating a thermoelectric conversion module 1 according to this embodiment is as follows: First thermoelectric conversion elements 2a, second thermoelectric conversion elements 2b, first electrodes 3a, second electrodes 3b, connecting electrodes 3c and extraction electrodes 3d are prepared and arranged between two punches functioning as conducting pressing members in a fabricating apparatus. Then, pressure is applied by pressing the punches to the first thermoelectric conversion elements 2a, second thermoelectric conversion elements 2b, first electrodes 3a, second electrodes 3b, connecting electrodes 3c and extraction electrodes 3d arranged between them while current is applied. As a result, the first electrodes 3a, the second electrodes 3b, the connecting electrodes 3c and the extraction electrodes 3d are diffusion-bonded (plasma-bonded) to the first and second thermoelectric conversion elements 2a, 2b, so that the first and second thermoelectric conversion elements 2a, 2b are connected in series, thus forming a series circuit including five series circuit elements 13. The application of pressure and current is performed within a vacuum chamber or a chamber with a nitrogen gas atmosphere or an inert gas atmosphere.

Next, the first and second thermoelectric conversion elements 2a, 2b with the first electrodes 3a, second electrodes 3b, connecting electrodes 3c and extraction electrodes 3d joined are mounted on a support substrate 6. More specifically, they are mounted with the second electrodes 3b bonded to a metal pattern formed on the support substrate 6 by a bonding material such as solder. The support substrate 6 thus supports the first and second thermoelectric conversion elements 2a, 3b with the first electrodes 3a, second electrodes 3b, connecting electrodes 3c and extraction electrodes 3d joined.

Next, a second covering layer 5 is formed by common insert molding, and then a first covering layer 4 is formed by insert molding, likewise. By this process, the thermoelectric conversion module 1 is completed.

### (Comparison between an example piece according to the embodiment and a comparative example piece)

Next, referring to table 1 below, test performed on a series circuit element 13 for forming a thermoelectric conversion module 1 according to the above embodiment (hereinafter referred to as "example piece") and a series circuit element prepared as a comparative example (hereinafter referred to as "comparative example piece") having a structure different from the series circuit element 13, and the result of the test will be described. The comparative example piece differs from the example piece in that in place of the first and second thermoelectric conversion elements 2a, 2a of stepped outer shape, thermoelectric conversion elements of cylindrical shape are used. In the performance comparison test, the example piece and the comparison example piece were heated to 80°C with a hand hot press, and resistance, voltage and electricity were measured using a digital ohm meter. The example piece and the comparative example piece were heated from the second electrode 3b side (which means the second cylindrical portion 12 side in the example piece).

### [Table 1]

**Table 1: Performance comparison between example piece and comparative example piece**

| | Resistance (mΩ) | Voltage (mV) | Electricity (µW) |
|---|---|---|---|
| Example piece | 19 | 7.5 | 740 |
| Comparative example piece | 12 | 4.5 | 420 |

As shown in table 1, the example piece was higher in resistance, voltage and electricity than the comparative example. From the performance evaluation based on the differences in resistance, voltage and electricity, it was found that the example piece showed an approximately 43% improvement in electricity generation performance as compared with the comparative example piece. This is because in the example piece, heat is applied to the side nearer to the second cylindrical portions smaller in volume, conducted to the first cylindrical portions greater in volume and dissipated, so that an increase in temperature of the first and second thermoelectric conversion elements 2a, 2b is suppressed. The electricity generation temperature of the thermoelectric conversion elements can be thus optimized by controlling conduction of heat from the heating source only by means of the difference in volume between the first and second cylindrical portions 11 and 12 of each thermoelectric conversion element, without changing the material composition of each thermoelectric conversion element. Optimizing the electricity generation temperature of the thermoelectric conversion elements improves the electricity generation efficiency of the thermoelectric conversion elements, and thus, of the thermoelectric conversion module 1.

As described above, in the present embodiment, the thermoelectric conversion elements constituting the thermoelectric conversion module 1 each have a first cylindrical portion (first structural portion) 11 and a second cylindrical portion (second structural portion) 12 different in volume. The thermoelectric conversion elements having such structure can be arranged with the second cylindrical portions 12 greater in volume located nearer to the heating-source side, or high-temperature side (or in other words, exposed to high temperature) and the first cylindrical portions 11 smaller in volume located nearer to the low-temperature side (namely, away from the heating-source side, or high-temperature side). This provides a possibility for controlling the conduction of heat in the thermoelectric conversion elements to optimize the electricity generation temperature of the thermoelectric conversion elements. In other words, in the thermoelectric conversion module 1 and the thermoelectric conversion elements according to the present embodiment, it is possible to optimize the electricity generation temperature of the thermoelectric elements by a simple means, namely only adjusting their shape, without changing their material composition, and thus, without entailing a significant increase in cost. The present embodiment can thus provide a thermoelectric conversion module 1 which can maintain high electricity generation performance even when applied to a relatively high-temperature heating source, and thermoelectric conversion elements which do not exhibit a decrease in electricity generation performance even in a relatively high-temperature environment.

### (Variants of the thermoelectric conversion element)

In the described embodiment, the thermoelectric conversion element consists of a first cylindrical portion 11 and a second cylindrical portion 12 different in volume. The thermoelectric conversion element is however not limited to this structure, although it is required that thermoelectric conversion element consist of a portion smaller in volume located nearer to the high-temperature side when the thermoelectric conversion module 1 is applied to a heating source and a portion greater in volume located nearer to the low-temperature side thereof. For example, each thermoelectric conversion element may have a cavity, as shown in FIGS. 6 and 7. FIGS. 6 and 7 schematically show variants of the thermoelectric conversion element.

More specifically, the thermoelectric conversion element 31 (made of a p-type or n-type semiconductor material) shown in FIG. 6 has a cylindrical outer shape. The thermoelectric conversion element 31 can be considered to consist of an upper-side first structural portion 31a and a lower-side second structural portion 31b, where the first structural portion 31a and the second structural portion 31b are identical in outer measurement and outer shape but only the second structural portion 31b has a cylindrical cavity 32. Because of the cavity 32, the first structural portion 31a is greater in volume than the second structural portion 31b although the first structural portion 31a and the second structural portion 31b are identical in outer measurement and outer shape.

The thermoelectric conversion element 41 (made of a p-type or n-type semiconductor material) shown in FIG. 7 has a cylindrical outer shape and a cavity 42 of truncated cone shape. Also the thermoelectric conversion element 41 can be considered to consist of an upper-side first structural portion 41a greater in volume and a lower-side second structural portion 41b smaller in volume.

The thermoelectric conversion elements 31, 41 shown in FIGS. 6, 7 can be arranged with the second structural portion 31b, 41b smaller in volume located nearer to the heating-source side, or high-temperature side and the first structural portion 31a, 41a greater in volume located nearer to the low-temperature side. This provides a possibility for controlling the conduction of heat in the thermoelectric conversion elements to optimize the electricity generation temperature of the thermoelectric conversion elements.

The thermoelectric conversion element is not limited to a cylindrical outer shape but may be, for example a quadrangular prism. Also in this case, it is required to provide a difference in volume between a first structural portion and a second structural portion of the thermoelectric conversion element by at least forming a cavity in the second structural portion located nearer to the high-temperature side. The thermoelectric conversion element may have an outer shape of a truncated cone or truncated pyramid, thereby providing a difference in outer measurement, and thus, in volume between a first structural portion and a second structural portion. Also in this case, the thermoelectric conversion element may have an appropriate cavity.

### Explanation of Reference Signs

- 1: Thermoelectric conversion module
- 2a: First thermoelectric conversion element
- 2b: Second thermoelectric conversion element
- 3a: First electrode
- 3b: Second electrode
- 3c: Connecting electrode
- 3d: Extraction electrode
- 4: First covering layer
- 5: Second covering layer
- 6: Support substrate
- 11: First cylindrical portion (first structural portion)
- 12: Second cylindrical portion (second structural portion)
- 13: Series circuit element

## Claims

1. A thermoelectric conversion module (1) applied to a heating source, comprising
a plurality of thermoelectric conversion elements (2a, 2b) arranged adjacent to each other,
first electrodes (3a) located away from the heating source and joined to first ends of the thermoelectric conversion elements (2a, 2b) to electrically connect the first ends of adjacent thermoelectric conversion elements (2a, 2b),
second electrodes (3b) located nearer to the heating source and joined to opposite, second ends of the thermoelectric conversion elements (2a, 2b) to electrically connect the second ends of adjacent thermoelectric conversion elements_(2a, 2b), wherein
the thermoelectric conversion elements (2a, 2b) each comprise a first structural portion (11) joined to the first electrode (3a) and a second structural portion (12) joined to the second electrode (3b), the second electrode (3b) being smaller in volume than the first electrode (3a), **characterised in that** the thermoelectric conversion elements (2a, 2b) are diffusion-bonded to the second electrodes (3b).

2. The thermoelectric conversion module (1) according to claim 1, wherein the second structural portion (12) is smaller in outer measurement than the first structural portion (11).

3. The thermoelectric conversion module (1) according to claim 2, wherein the first structural portion (11) and the second structural portion (12) are cylindrical in shape, and the second structural portion (12) is smaller in diameter than the first structural portion (11).

4. The thermoelectric conversion module (1) according to claim 1 4 , wherein the second structural portion (12) has a cavity.

5. The thermoelectric conversion module (1) according to claim 4, wherein the first structural portion (11) has a cavity smaller than the cavity in the second structural portion (12).

## Patentansprüche

1. Thermoelektrisches Umwandlungsmodul (1), umfassend
eine Mehrzahl von nebeneinander angeordneten thermoelektrischen Umwandlungselementen (2a, 2b),
erste Elektroden (3a), die mit ersten Enden der thermoelektrischen Umwandlungselemente (2a, 2b) verbunden sind, um die ersten Enden benachbarter thermoelektrischer Umwandlungselemente (2a, 2b) elektrisch zu verbinden, und
zweite Elektroden (3b), die mit entgegengesetzten, zweiten Enden der thermoelektrischen Umwandlungselemente (2a, 2b) verbunden sind, um die zweiten Enden benachbarter thermoelektrischer Umwandlungselemente (2a, 2b) elektrisch zu verbinden, wobei
die durch die ersten und zweiten Elektroden (3a, 3b) elektrisch verbundenen thermoelektrischen Umwandlungselemente (2a, 2b) mindestens ein Reihenschaltungselement bilden und
wobei an den Enden des Reihenschaltungselements (13) dritte, flexible Elektroden (3c) vorgesehen sind,
ferner umfassend:
eine erste Deckschicht (4), die zum Abdecken der ersten Elektroden (3a) vorgesehen ist, und zwar in solcher Weise, dass die ersten Elektroden (3a) darin vergraben sind, und eine zweite Deckschicht (5), die zum Abdecken der dritten Elektroden (3c), der thermoelektrischen Umwandlungselemente (2a, 2b) und der zweiten Elektroden (3b) vorgesehen ist, und zwar in solcher Weise, dass diese darin vergraben sind,
wobei die erste Deckschicht (4) und die zweite Deckschicht (5) ein Material enthalten, das als wärmeleitendes Material fungiert, und wobei die zweite Deckschicht (5) eine geringere Wärmeleitfähigkeit aufweist als die erste Deckschicht (4).

2. Thermoelektrisches Umwandlungsmodul (1) nach Anspruch 1, mit einer Mehrzahl der Reihenschaltungselemente (13), wobei die Reihenschaltungselemente (13) durch die dritten Elektroden (3c) miteinander verbunden sind.

3. Thermoelektrisches Umwandlungsmodul (1) nach Anspruch 1 oder 2, wobei die dritte Elektrode (3c) ein Metallgitter umfasst.

4. Thermoelektrisches Umwandlungsmodul (1) nach Anspruch 3, wobei die dritte Elektrode (3c) Metallplatten enthält, die an dem Metallgitter an gegenüberliegenden Enden befestigt sind.

5. Thermoelektrisches Umwandlungsmodul (1) nach einem der Ansprüche 1 bis 4, wobei die ersten und die zweiten Elektroden (3a, 3b) flexibel sind.

## Revendications

1. Module de conversion thermoélectrique (1), comprenant
une pluralité d'éléments de conversion thermoélectrique (2a, 2b) agencés adjacents les uns aux autres,
des premières électrodes (3a) reliées à des premières extrémités des éléments de conversion thermoélectrique (2a, 2b) pour connecter électriquement les premières extrémités d'éléments de conversion thermoélectrique (2a, 2b) adjacents, et
des deuxième électrodes (3b) reliées à des deuxièmes extrémités, opposées, des éléments de conversion thermoélectrique (2a, 2b) pour connecter électriquement les deuxièmes extrémités d'éléments de conversion thermoélectrique (2a, 2b) adjacents, où
les éléments de conversion thermoélectrique (2a, 2b) connectés électriquement par les premières et deuxièmes électrodes (3a, 3b) forment au moins un élément de circuit en série, et
des troisième électrodes (3c) ayant une flexibilité sont prévues à des extrémités de l'élément de circuit en série (13),
comprenant en outre :
une première couche de couverture (4) prévue pour couvrir les premières électrodes (3a) de manière à ce que les premières électrodes (3a) y soient enfouies, et
une deuxième couche de couverture (5) prévue pour recouvrir les troisièmes électrodes (3c), les éléments de conversion thermoélectrique (2a, 2b), et les deuxièmes électrodes (3b) de manière à ce qu'ils y soient enfouis,
dans lequel la première couche de couverture (4) et la deuxième couche de couverture (5) contiennent un matériau fonctionnant en tant que matériau thermo-conducteur, et dans lequel la deuxième couche de couverture (5) a une conductivité thermique inférieure à celle de la première couche de couverture (4).

2. Module de conversion thermoélectrique (1) selon la revendication 1, comprenant une pluralité d'éléments de circuit en série (13), dans lequel
les éléments de circuit en série (13) sont connectés entre eux par les troisièmes électrodes (3c).

3. Module de conversion thermoélectrique (1) selon la revendication 1 ou 2, dans lequel la troisième électrode (3c) comporte un treillis métallique.

4. Module de conversion thermoélectrique (1) selon la revendication 3, dans lequel la troisième électrode (3c) comporte des plaques métalliques fixées au treillis métallique à des extrémités opposées.

5. Module de conversion thermoélectrique (1) selon l'une quelconque des revendications 1 à 4, dans lequel les premières et deuxièmes électrodes (3a, 3b) ont une flexibilité.
